# EUROPEAN PATENT SPECIFICATION

(11) **EP 0 696 852 B1**
(45) Date of publication and mention of the grant of the patent: **27.11.2002**
(21) Application number: 95112331.4
(22) Date of filing: 04.08.1995
(51) Int. Cl.: H04B 1/10, H04B 1/16, H03G 3/34

(54) **FM receiver**
FM-Empfänger
Récepteur FM

(30) Priority: 11.08.1994 JP 21059294
(43) Date of publication of application: 14.02.1996
(73) Proprietor: PIONEER ELECTRONIC CORPORATION, Meguro-ku, Tokyo (JP)
(72) Inventor: Akiyama, Kiichiro, c/o Kawagoe Koujou, Pioneer, Kawagoe-shi, Saitama-ken (JP); Horigome, Fumihiko, c/o Kawagoe Koujou, Pioneer, Kawagoe-shi, Saitama-ken (JP); Ichikawa, Toshihito, c/o Kawagoe Koujou, Pioneer, Kawagoe-shi, Saitama-ken (JP)
(74) Representative: Popp, Eugen, Dr.

(56) References cited:
- EP-A- 0 427 164
- EP-A- 0 512 374
- US-A- 4 688 265
- FUNKSCHAU, vol. 65, no. 10, 30 April 1993, pages 8-10, 12, 14, 16 - 17, 22 - 23, XP000362401 "KEINE CHANCE FUER AUTORADIOS MIT NEUER EMPFANGSTECHNIK"
- PATENT ABSTRACTS OF JAPAN vol. 009, no. 081 (E-307), 10 April 1985 & JP 59 212037 A (YAESU MUSEN KK), 30 November 1984,

## Description

### BACKGROUND OF THE INVENTION

The present invention relates to an FM receiver provided with an IF filter which restricts passages of IF signals in a certain band, and more particularly to an FM receiver wherein the range of the band is variable.

There has been known an FM radio receiver where a pass band of an IF filter can be changed in accordance with the occurrence of interferences such as a multi-path reflection interference and adjacent channel interference.

The article "Keine Chance für Autoradios mit never Empfangstechnik" from the magazine "Funkschau", vol. 65, no. 10, 30 April 1993 describes a FM receiver with inter-frequency filters with different passband widths, the use of which is controlled by a receiving condition detector.

Document US-A-4688265 contains a noise blanking circuit with variable blanking period length.

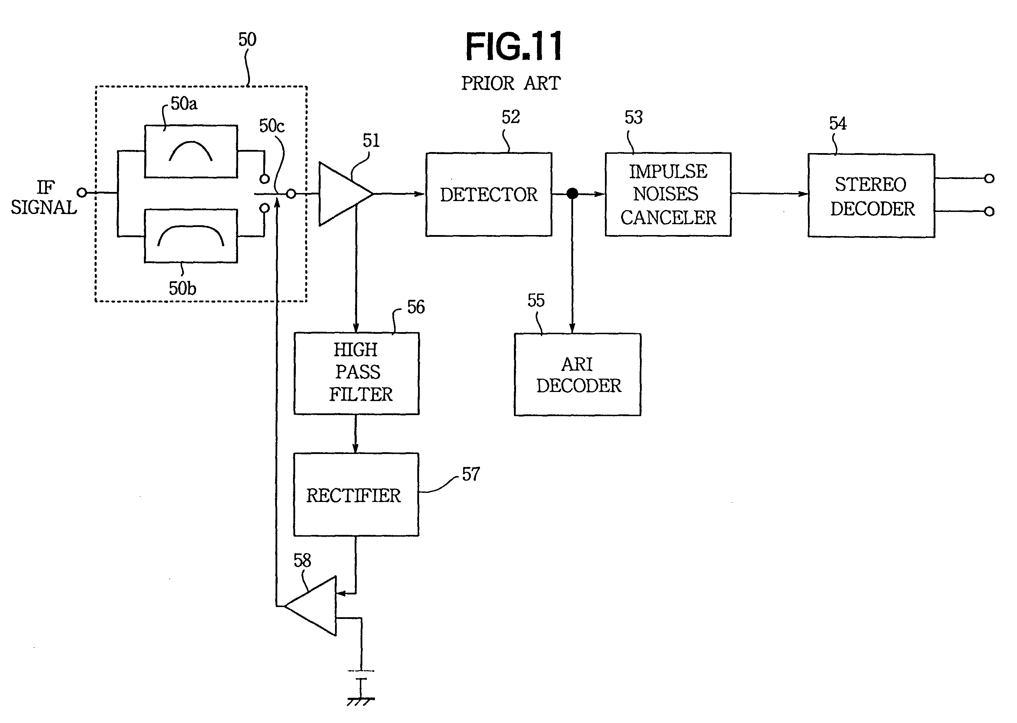

Referring to Fig. 11, an IF signal from a front end (not shown) of an FM receiver is fed either to a narrow pass band IF filter 50a or a wide pass band IF filter 50b depending on a changeover switch 50c. The wide pass band IF filter 50b is selected when the broadcast wave is tuned in without trouble and the narrow pass band IF filter 50a is selected when an interference such as an adjacent channel interference occurs. The IF signal is further applied to a detector 52 through an IF amplifier 51, so that the IF signal is demodulated into a composite signal. Impulse noises are eliminated from the demodulated composite signal at an impulse noise canceler 53. The composite signal is thereafter applied to a stereo decoder 54 from which right and left audio signals are produced.

The modulated composite signal from the detector 52 is further applied to an ARI decoder 55 which decodes a data signal multiplexed on a main signal of the composite signal. When the decoded data signal indicates that the receiving broadcast wave is transmitted from a traffic information broadcast station (SK station), the ARI decoder 55 applies a signal to an indicator (not shown) to operate it, thereby informing the user.

A field strength output is extracted from the IF amplifier 51, and applied to a high-pass IF filter 56 which extracts a high-frequency component included in the field strength output. The high-frequency component is rectified by a rectifier 57 and then the level thereof is compared with a reference level at a comparator 58. When the level of the high-frequency component is higher than the reference level, it is determined that the receiving condition is poor due to the interferences. The comparator 58 accordingly applies a signal to the changeover switch 50c so as to connect the switch 50c with the narrow band IF filter 50a.

Such an FM receiver is advantageous in that the influence of the adjacent channel interference is restrained. However, the narrow pass band of the IF filter causes various troubles which will now be described.

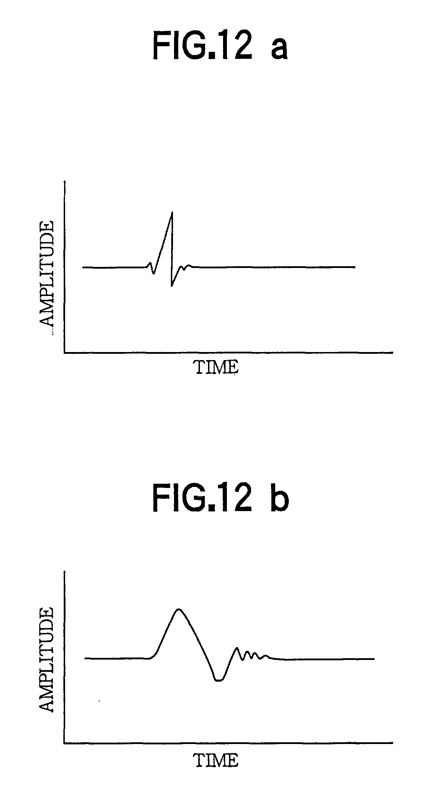

As shown in Fig. 12a, an impulse noise included in the input IF signal passing through the wide band IF filter gives a sharp pulse shape. On the other hand, when the narrow band IF filter is selected, since the high-frequency component is mostly eliminated, the pulse shape is deformed and becomes dull as shown in Fig. 12b. The conventional noise canceler, when detecting an impulse noise, is operated to gate the output so that the noise is not fed to latter devices in the receiver. If the waveform of the noise is thus deformed as shown in Fig. 12b, the duration of the pulse becomes longer. A gating period of the impulse noise canceler 53 set appropriate for the wide band IF filter 50b may not be sufficient when the narrow band IF filter 50a is selected. Thus, the impulse noise cannot be completely eliminated. To the contrary, if the gating period is set sufficiently long for the narrow band IF filter 50a, while the wide band IF filter is selected, the signal besides the noise is also eliminated, so that the signal received by the FM receiver cannot be accurately reproduced.

Another drawback of using the narrow band IF filter 10a is that an overmodulated broadcast wave may cause a distortion in the output of the detector 52. A tertiary higher harmonic which occurs in the pilot signal of the FM waves, the frequency of which is 19 kilohertz, affects on an ARI signal, the frequency of which is the triple of that of the pilot signal, namely 57 kilohertz. The ARI decoder 55 accordingly determines that an SK signal is received so that the indicator erroneously shows that the traffic information broadcast station is tuned in.

Furthermore, since the high-frequency component is eliminated from the demodulated signal when the narrow band IF filter is selected, the volume of the reproduced sound is decreased than when the wide band IF filter is used. The listener, hence will feel an interruption whenever the band IF filter is changed.

### SUMMARY OF THE INVENTION

An object of the present invention is to provide an FM receiver wherein an impulse noise is infallibly eliminated in accordance with the selected pass band IF filter.

Another object of the present invention is to provide an FM receiver wherein an indicator for indicating the receipt of the traffic information broadcast wave is accurately operated.

Another object is to provide an FM receiver where the volume of the reproduced sound is maintained constant despite the change of the IF filter.

According to the present invention, there is provided an FM receiver having an IF filter including a narrow pass band filter, a wide pass band filter, and a changeover switch for selecting one of the band filters, a detector for receiving an IF signal from the IF filter and for producing a composite signal, a noise canceler for detecting pulse noises included in the composite signal and for producing a gating signal having a gating period for stopping the composite signal during the period, and a receiving condition detector which detects receiving condition of the FM receiver and produces a pass band control signal for operating the changeover switch for selecting the pass band of the IF filter.

The receiving condition detector applies the pass band control signal to the changeover switch of the IF filter to select the narrow pass band filter when a deterioration of the receiving condition is detected, the receiving condition detector produces a gating period changing signal when the deterioration of the receiving condition is detected, and the noise canceler has gate means, and control means responsive to the gating period changing signal for changing the gating period.

The other objects and features of this invention will become understood from the following description with reference to the accompanying drawings.

### BRIEF DESCRIPTION OF DRAWINGS

Fig. 1 is a block diagram of an FM receiver according to the present invention;
Fig. 2 is a block diagram of an impulse noise canceler provided in the FM receiver of Fig. 1;
Fig. 3 is a block diagram of an FM receiver according to a second embodiment the present invention;
Fig. 4 is a block diagram of a traffic information decoder provided in the FM receiver of Fig,3;
Fig. 5 is a block diagram of an FM receiver according to a third embodiment the present invention;
Fig. 6 is a block diagram of a low-frequency amplifier provided in the FM receiver of Fig. 5;
Fig. 7 is block diagram of an example of a receiving condition detector provided in the FM receiver of the present invention;
Fig. 8 is a block diagram of a modification of the receiving condition detector;
Figs. 9a to 9c are graphs showing waveforms of a signal at various stages of the receiving condition detector of Fig. 8;
Fig. 10 is a block diagram of another modification of the receiving condition detector;
Fig. 11 is a block diagram of a conventional FM receiver; and
Figs. 12a and 12b are graphs showing waveforms of impulse noises which occur in a wide band IF filter and in a narrow band IF filter, respectively.

### DETAILED DESCRIPTION OF THE PREFERRED EMBODIMENTS

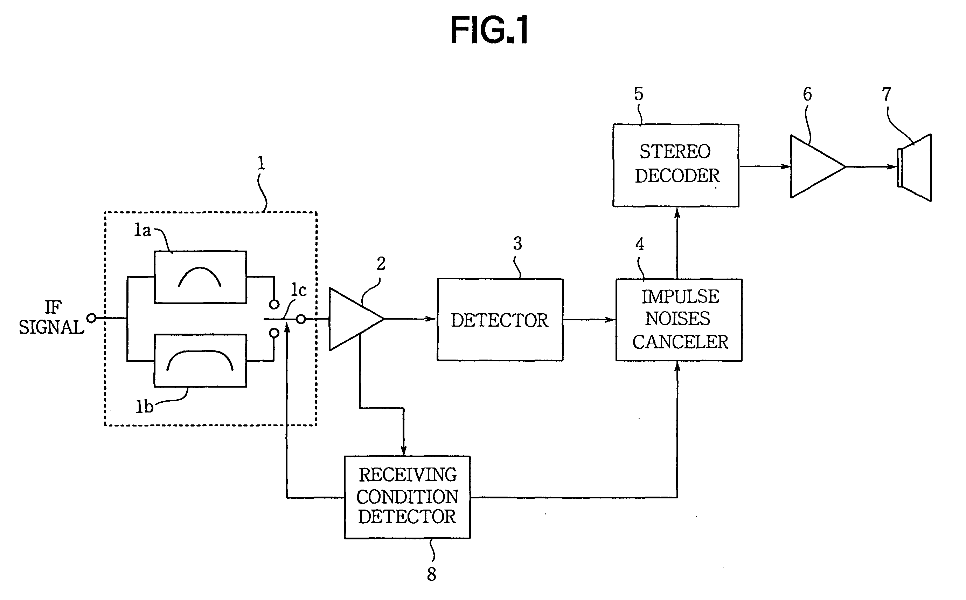

Referring to Fig. 1 an FM receiver according to the present invention has an IF filter device 1 comprising a narrow band IF filter 1a, a wide band IF filter 1b, and a changeover switch 1c, the movable contact of which selectively connected to the narrow band IF filter 1a or to the wide band IF filter 1b. Under a normal operating condition where the receiving condition is satisfactory, the wide band IF filter 1b is selected. Hence, an input IF signal applied through a front end (not shown) of the FM receiver is fed through the wide band IF filter to an IF amplifier 2 to be amplified, and further to a detector 3 which demodulates the IF filter to produce a composite signal. The demodulated composite signal, after being eliminated of impulses noises included therein by an impulse noise canceler 4, is fed to a stereo decoder 5. The stereo decoder 5 produces a stereo audio signal based on the composite signal, which is further fed to a speaker 7 through a low-frequency amplifier 6 so as to be reproduced.

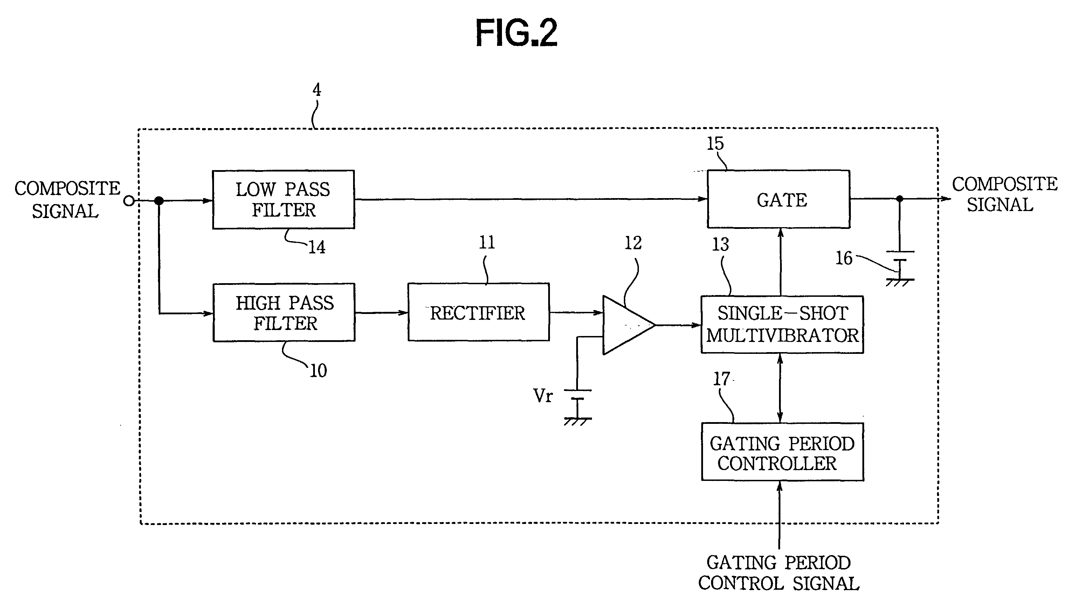

Referring to Fig. 2, showing an example of the impulse noise canceler 4, the demodulated composite signal from the detector 3 is fed to the stereo decoder 5 through a low-pass filter 14 and a gate 15. The composite signal is further fed to a high-pass filter 10 so that a high-frequency noise component is extracted therefrom. The high-frequency component is fed to a rectifier 11 where the signal is converted into a direct current the value of which is compared with a predetermined reference value Vr by a comparator 12. When the level of the high-frequency noise component is higher than the reference value Vr, determining that a impulse noise is equivalently generated, the comparator 12 applies an impulse noise detecting signal to a single-shot multivibrator 13. The single-shot multivibrator 13, in response to the impulse noise detecting signal, applies a pulse signal to a gate 15 to which the composite signal from the low-pass filter 14 is fed thereby to close the gate 15 for a predetermined period dependent on the single-shot multivibrator 13. Hence, when the impulse noise occurs, the impulse noise is prevented from being transmitted to the latter devices of the FM receiver. A capacitor 16 is provided to prevent the voltage from dropping when the gate 15 is closed. The low-pass filter 14 delays the transmission of the composite signal so that the composite signal reaches the gate 15 at the closing timing. The impulse noise canceler 4 further has a gating period controller 17 for controlling the gating period of the gate 15, the operation of which will be later described in detail.

Referring back to Fig. 1, the output field strength from the IF amplifier 2, is fed to a receiving condition detector 8 for determining the receiving condition of a broadcast so that the narrow band IF filter 1a or the wide band IF filter 1b is appropriately selected.

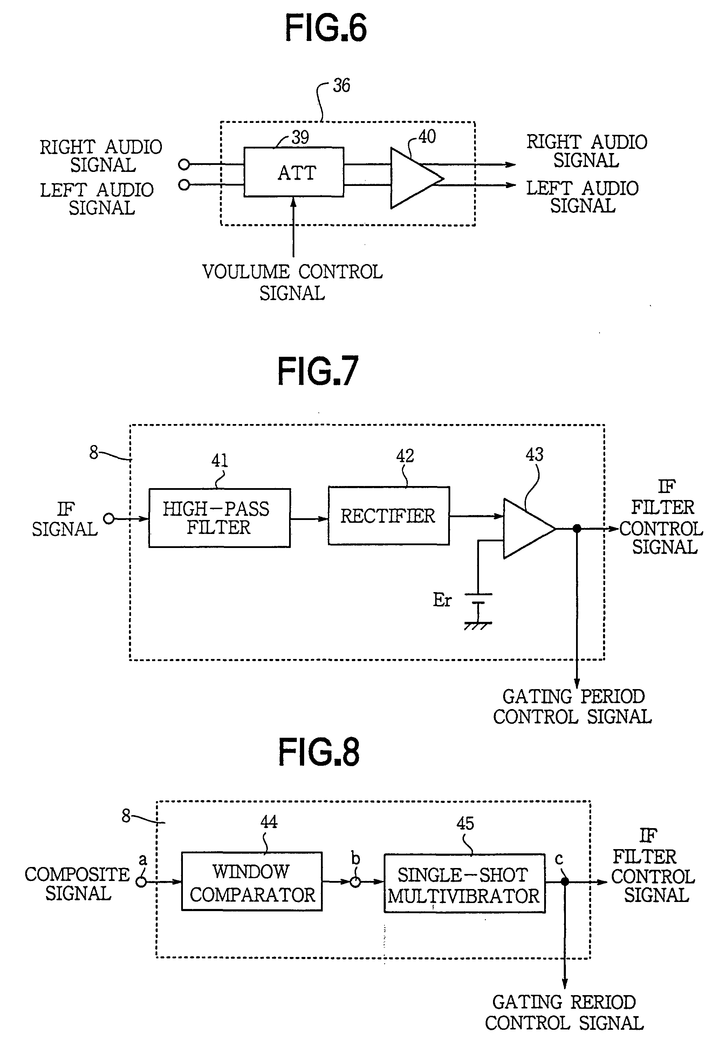

Referring Fig. 7, an example of the receiving condition detector 8 for detecting an interference such as an adjacent channel interference and a multi-path reflection interference comprises a high pass filter 41 to which the IF signal is fed, a rectifier 42 and a comparator 43. The high pass filter 41 passes an alternating-current component in the IF signal. The alternating-current component is rectified by the rectifier 42 and fed to the comparator 43 so as to compare the level thereof with a reference electric potential Er. When there is a noise so that the level of the alternating-current component becomes higher than the reference potential Er, it is determined that the receiving condition of the broadcast is poor due to adjacent channel interference or a multi-path reflection interference. Hence the comparator 43 produces an IF filter control signal which is fed to the changeover switch 1c of the IF filter device 1. The changeover switch 1c is accordingly operated to connect the narrow band IF filter 1a to the IF amplifier 2. Thus unwanted signals are eliminated by the narrow band IF filter 1a so that the broadcast can be reproduced without noises.

At the same time, the receiving condition detector 8 feeds a gating period control signal to the gating period controller 17 of the impulse noise canceler 4. When the control signal is fed, the gating period controller 17 applies a signal to the single-shot multivibrator 13 so that the pulse width of the pulse signal is elongated. Namely, when interference occurs so that the narrow band IF filter 1a (Fig. 1) is selected, the gating period at the gate 15 automatically becomes longer. Hence, the impulse noise can be accurately eliminated although the duration thereof becomes longer. During the normal state where the wide band pass filter 1b is selected, the gating period is kept short so that unnecessary cutting off of the audio signal does not occur.

The present embodiment may be modified so as to increase the sensitivity of the impulse noise canceler so that impulse noise is detected with more accuracy when the narrow band IF filter is selected. The same result as when the gating period is prolonged can be obtained.

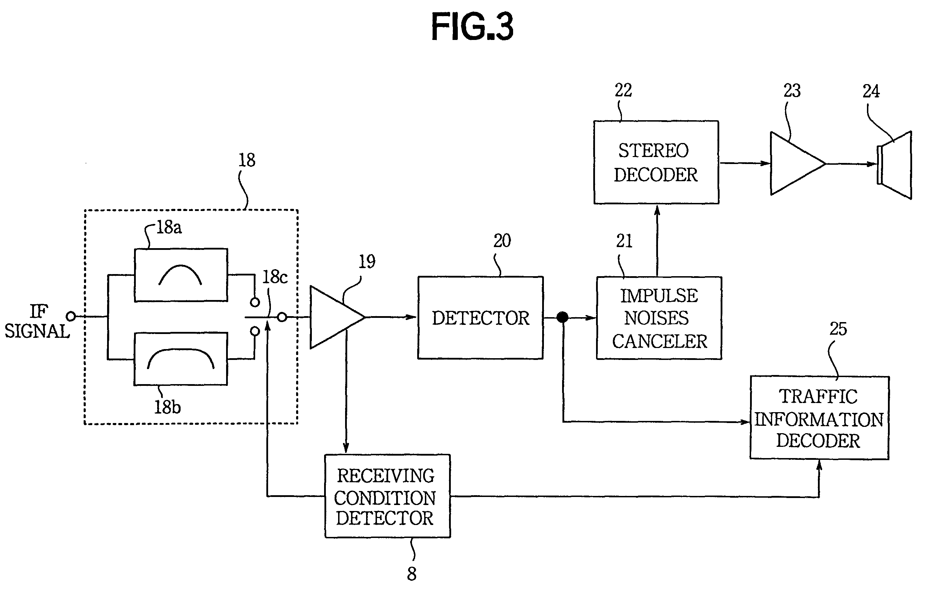

Referring to Fig. 3, an FM receiver according to the second embodiment of the present invention comprises an IF filter device 18 having a narrow band IF filter 18a, a wide band IF filter 18b and a changeover switch 18c. The IF signal is fed through one of the filters 18a and 18b to an IF amplifier 19 and a detector 20 so as to be demodulated into a composite signal. The impulse noise in the composite signal is eliminated at an impulse noise canceler 21. The composite signal is further converted into a stereo audio signal at a stereo decoder 22, which is fed to a speaker 24 through a low-frequency amplifier 23. The IF signal from the IF amplifier 19 fed to the receiving condition detector 8, which is shown in Fig. 7, to determine whether the current receiving condition is poor due to interferences such as adjacent channel interference. The receiving condition detector 8 is operated in the same manner as in the first embodiment, hence selecting either of the IF filters 18a and 18b as appropriate.

The FM receiver of the second embodiment is further provided with a traffic information decoder 25 to which the composite signal from the detector 20 is applied. The traffic information decoder 25 detects a traffic information data signal multiplexed over a main signal of broadcast signal transmitted to the receiver.

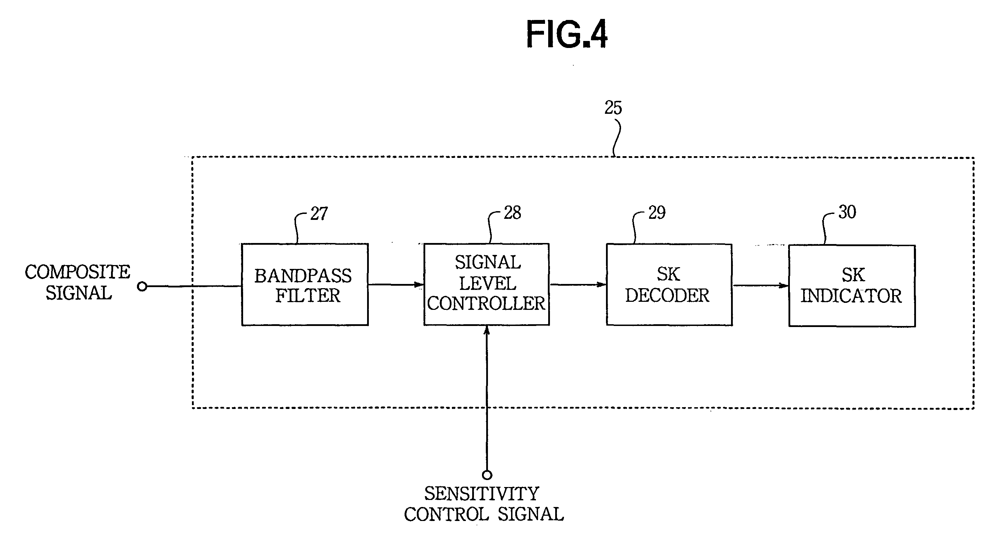

Referring to Fig. 4, showing the traffic information decoder 25 in detail, the demodulated composite signal from the detector 20 is fed to a bandpass filter 27 which, in the case of a traffic information broadcast composite signal, extracts traffic information data signal multiplexed over the main signal. The extracted traffic information data signal is fed through a signal level controller 28 to an SK decoder 29 for decoding identification data from the traffic information data signal. When the identification data is that of the traffic information broadcast, an SK indicator 30 is operated, informing the user that the FM receiver is currently tuned in to a traffic information broadcast station.

The receiving condition detector 8 of the second embodiment, at the time of a poor reception, further produces a sensitivity control signal which is fed to the signal level controller 28 of the traffic information decoder 25. The signal level controller 28 is accordingly operated as an attenuator thereby decreasing the level of the traffic information data signal.

In operating during the overmodulation of the broadcast signals, when the narrow band IF signal is selected, the composite signal is liable to be distorted. Hence the pilot signal of the FM broadcast composite signal may pass the bandpass filter 27 as if the traffic information data signal, thereby causing the SK indicator 30 to erroneously indicate the receipt of the traffic information broadcast. However, since the level of the pilot signal is automatically decreased while the narrow band IF filter 18a is selected, it is impossible for the SK decoder 29 to erroneously detect the pilot signal as the SK signal. The SK indicator 30 is thus kept inoperative. On the other hand, when the receiving condition is improved so that the wide band IF filter 18b is selected, the composite signal fed to the traffic information decoder 25 is not attenuated, hence increasing the sensitivity of the SK decoder, thus accurately operating the indicator.

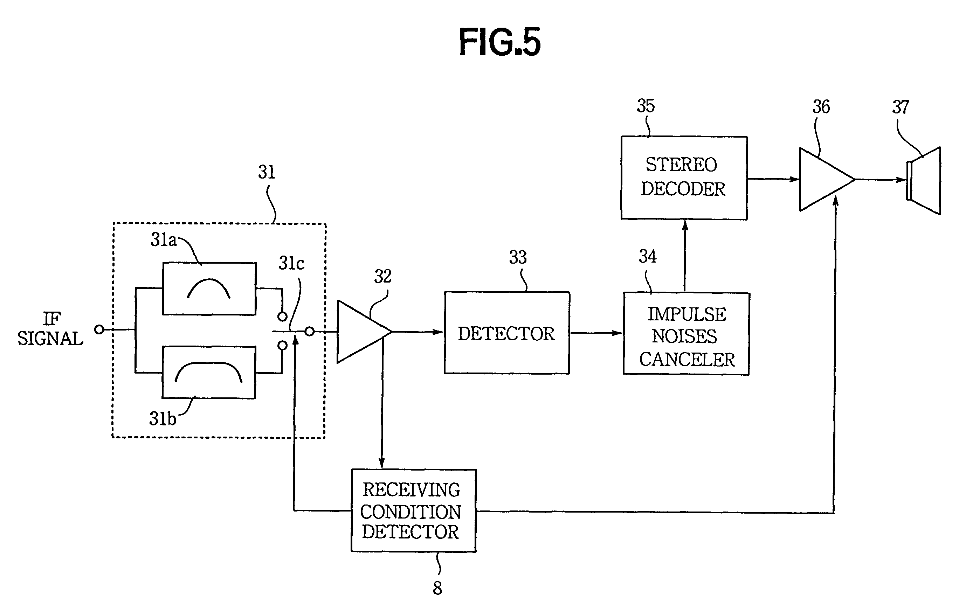

Referring to Fig. 5, an FM receiver according to the third embodiment of the present invention comprises an IF filter device 31 having a narrow band IF filter 31a, a wide band IF filter 31b and a changeover switch 31c. The IF signal is fed through one of the filters 31a and 31b to an IF amplifier 32 and a detector 33 so as to be demodulated into a composite signal. The impulse noise in the composite signal is eliminated at an impulse noise canceler 34. The composite signal is further converted into a stereo audio signal at the stereo decoder 35, which is fed to a speaker 37 through a low-frequency amplifier 36.

Referring to Fig. 6, an example of the low-frequency decoder 36 comprises an attenuator 39 and an amplifier 40. The attenuator 30 adjusts the volumes of right and left audio signals derived at the stereo decoder 35.

The IF signal from the IF amplifier 32 is fed to the receiving condition detector 8 which is shown in Fig. 7 to determine whether the current receiving condition is poor due to interferences such as adjacent channel interference. The receiving condition detector 8 is operated in the same manner as in the first embodiment, hence selecting either of the IF filters 31a and 31b as appropriate.

The receiving condition detector 8 of the third embodiment further produces a volume control signal which is fed to the low-frequency amplifier 36 as shown in Fig. 5 to increase the volume of the sound emitted from the speaker 37. Namely, when the receiving condition of the FM receiver is deteriorated so that the narrow band IF filter 31a is selected, the receiving condition detector 8 applies the volume control signal to the attenuator 39 of the low-frequency amplifier 36. The attenuator 39 therefore decreases the attenuating quantity of the right and left audio signals which are fed to the speaker 37 through the amplifier 40. As a result, the volume is increased.

Thus, although the narrow band IF filter decreases the volume of the high-frequency component, the loss is automatically compensated by increasing the volume of the low and middle-frequency components. While the wide band IF filter 31b is being selected, the reproduced sound includes those in low to high-frequencies so that the high quality of the sound is maintained. The change of the IF filter with the deterioration of the receiving condition does not cause abrupt change in the volume, so that the broadcast is not interrupted.

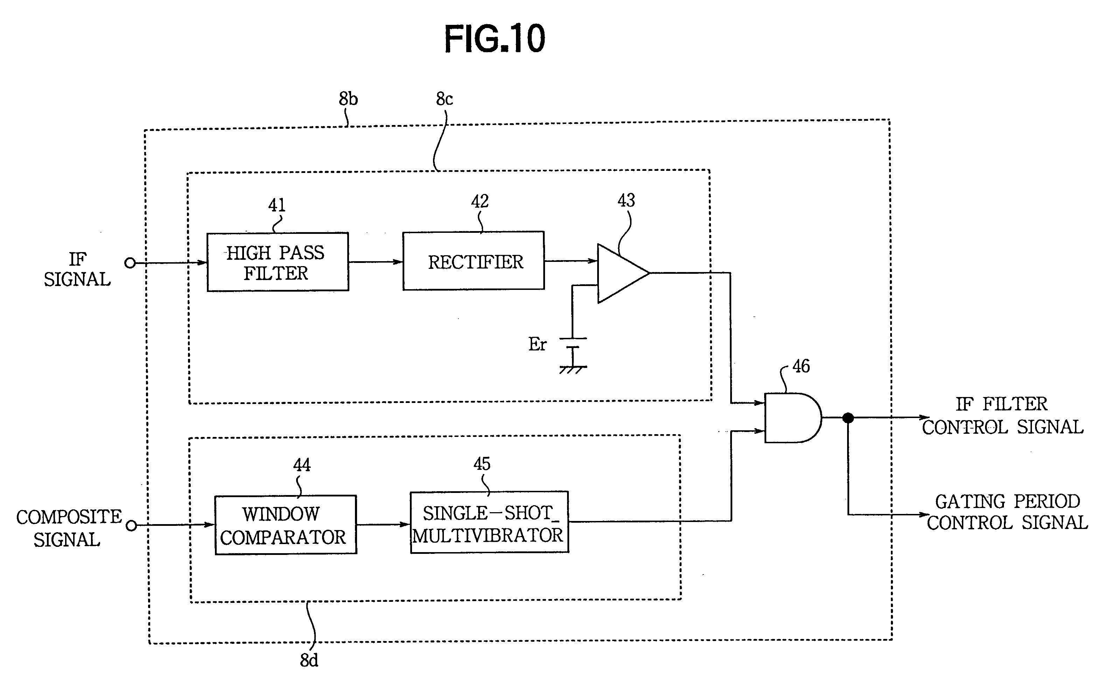

Figs. 8 and 10 show modifications of the receiving condition detector which can be provided in any of the FM receivers shown in Figs. 1, 3 and 5.

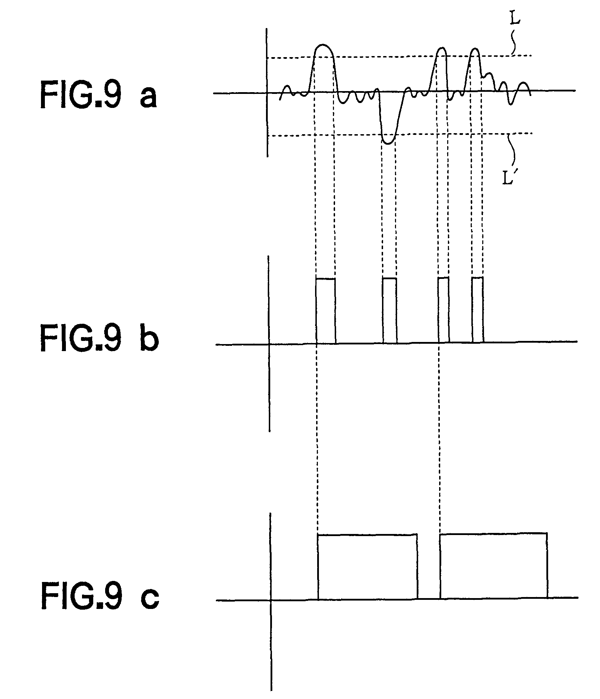

Referring to Fig. 8, a receiving condition detector 8a detects whether the incoming broadcast wave is overmodulated. The receiving condition detector 8a has a window comparator 44 and a single-shot multivibrator 45. A demodulated composite signal shown in Fig. 9a is fed from a detector, for example, the detector 2 in Fig. 1, to the window comparator 44 through a terminal a. The window comparator 44 compares the level of the composite signal with predetermined reference levels L and L' in Fig. 9a, and produces, at a terminal b, pulse signals each having a width which corresponds to the duration in which the composite signal exceeds the reference level, as shown in Fig. 9b. The pulse signal is fed to a single-shot multivibrator 45 which produces a pulse having a wide width so that repeated changes of the signal levels can be prevented.

Namely, at a terminal c, a pulse shown in Fig. 9c is generated. The pulse means that the broadcast is overmodulated. More particularly, the single-shot multivibrator 45 applies the pulse to the IF filter device, thereby changing the filter device into the narrow band IF filter during the pulse. The gating period control signal, sensitivity control signal and the volume control signal in the first, second and third embodiments, respectively, are further produced based on the pulse.

Referring to Fig. 10, a receiving condition detector 8b comprises an interference detecting section 8c and an overmodulation detecting section 8d. The interference detecting section 8c has the same construction as the receiving condition detector 8 shown in Fig. 7 and is applied with the IF signal. The overmodulation detecting section 8d has the same construction as the receiving condition detector 8a as shown in Fig. 8 and is applied with the demodulated composite signal. The outputs of the detecting sections 8c and 8d are fed to an AND gate 46, the output of which is fed to the IF filter device as the IF filter control signal and to the impulse noise canceler 4, traffic information decoder 25 or the low-frequency amplifier 36 as the gating period control signal, sensitivity control signal or the volume control signal, respectively as the circumstance calls for.

While the presently preferred embodiments of the present invention have been shown and described, it is to be understood that these disclosures are for the purpose of illustration and that various changes and modifications may be made without departing from the scope of the invention as set forth in the appended claims.

## Claims

1. An FM receiver having an IF filter (1; 18; 31) including a narrow pass band filter (1a; 18a; 31a), a wide pass band filter (1b; 18b; 31b), and a changeover switch (1c; 18c; 31c) for selecting one of the band filters, a detector (3; 20; 33) for receiving an IF signal from the IF filter (1; 18; 31) and for producing a composite signal, a noise canceler (4; 21; 34) for detecting pulse noises included in the composite signal and for producing a gating signal having a gating period for stopping the composite signal during the period, and a receiving condition detector (8) which detects receiving conditions of the FM receiver and produces a pass band control signal for operating the changeover switch (1c; 18c; 31c) for selecting the pass band of the IF filter (1; 18; 31),
**characterized in that**
- the receiving condition detector (8) applies the pass band control signal to the changeover switch (1c; 18c; 31c) of the IF filter (1; 18; 31) to select the narrow pass band filter (1a; 18a; 31a) when a deterioration of the receiving condition is detected;
- the receiving condition detector (8) produces a gating period changing signal when the deterioration of the receiving condition is detected;
- the noise canceler (4; 21; 34) has gate means (15), and control means (17) responsive to the gating period changing signal for changing the gating period.

2. The FM receiver according to claim 1 further comprising a traffic information decoder (25) for detecting traffic information multiplexed in a main signal of a broadcast signal and for producing a traffic information signal which is applied to the noise canceler (21); the receiving condition detector (8) being arranged to produce a reduction signal for reducing the level of the traffic information signal when the deterioration of the receiving condition is detected.

3. The FM receiver according to claim 1 further comprising sound volume changing means (36), the receiving condition detector (8) applying a sound volume control to the volume changing means (36) for increasing the volume when the deterioration of the receiving condition is detected.

4. The FM receiver according to claim 1 wherein the gate means (15) has a single-shot multivibrator (13) for changing the gating period.

## Patentansprüche

1. FM-Empfänger mit einem Zwischenfrequenzfilter (1; 18; 31), das ein Schmalbandpassfilter (1a; 18a; 31a), ein Breitbandpassfilter (1b; 18b; 31b) und einen Umschalter (1c; 18c; 31c) zur Auswahl eines der Bandfilter umfasst, einem Detektor (3; 20; 33) zum Empfangen eines Zwischenfrequenzsignals aus dem Zwischenfrequenzfilter (1; 18; 31) und zum Erzeugen eines Mischsignals, einem Rauschunterdrücker (4; 21; 34) zum Erfassen von Impulsrauschen, das im Mischsignal enthalten ist, und zum Erzeugen eines Auswertesignals mit einem Auswertezeitraum, um das Mischsignal während des Zeitraums zu sperren, und einem Empfangszustandsdetektor (8), der die Empfangszustände des FM-Empfängers erfasst und ein Durchlassbereich-Steuersignal zur Betätigung des Umschalters (1c; 18c; 31c) zur Auswahl des Durchlassbereichs des Zwischenfrequenzfilters (1; 18; 31) erzeugt,
**dadurch gekennzeichnet, dass**
- der Empfangszustandsdetektor (8) das Durchlassbereich-Steuersignal an den Umschalter (1c; 18c; 31c) des Zwischenfrequenzfilters (1; 18; 31) anlegt, um das Schmalbandpassfilter (1a; 18a; 31a) auszuwählen, wenn eine Verschlechterung des Empfangszustands erfasst wird;
- der Empfangszustandsdetektor (8) ein Auswertezeitraumänderungssignal erzeugt, wenn die Verschlechterung des Empfangszustands erfasst wird;
- der Rauschunterdrücker (4; 21; 34) Auswerteeinrichtungen (15) und Steuereinrichtungen (17) aufweist, die auf das Auswertezeitraumänderungssignal ansprechen, um den Auswertezeitraum zu verändern.

2. FM-Empfänger nach Anspruch 1, darüber hinaus umfassend einen Verkehrsnachrichtendecodierer (25) zum Erfassen von Verkehrsnachrichten, die in einem Hauptsignal eines Rundfunksignals multiplexiert sind, und zum Erzeugen eines Verkehrsnachrichtensignals, das an den Rauschunterdrücker (21) angelegt wird;
wobei der Empfangszustandsdetektor (8) angeordnet ist, um ein Reduktionssignal zur Reduzierung des Pegels des Verkehrsnachrichtensignals zu erzeugen, wenn die Verschlechterung des Empfangszustands erfasst wird.

3. FM-Empfänger nach Anspruch 1, darüber hinaus umfassend eine Lautstärkereglereinrichtung (36), wobei der Empfangszustandsdetektor (8) eine Lautstärkesteuerung an die Lautstärkereglereinrichtung (36) anlegt, um die Lautstärke zu erhöhen, wenn die Verschlechterung des Empfangszustands erfasst wird.

4. FM-Empfänger nach Anspruch 1, bei dem die Auswerteeinrichtungen (15) eine monostabile Kippschaltung (13) zum Verändern des Auswertezeitraums aufweisen.

## Revendications

1. Récepteur F.M. possédant un filtre IF (1 ; 18 ; 31) comprenant un filtre passe-bande à bande étroite (1a ; 18a ; 31a), un filtre passe-bande à bande large (1b ; 18b ; 31b) et un commutateur d'inversion (1c; 18c ; 31c) pour sélectionner un des filtres de bande, un détecteur (3 ; 20 ; 33) pour recevoir un signal IF du filtre IF (1 ; 18 ; 31) et pour produire un signal composite, un moyen d'annulation du bruit (4 ; 21 ; 34) pour détecter des bruits par impulsion inclus dans le signal composite et pour produire un signal de déclenchement possédant une période de déclenchement pour arrêter le signal composite lors de la période, et un détecteur de condition de réception (8) détectant des conditions de réception du récepteur F.M. et produisant un signal de commande passe-bande pour actionner le commutateur d'inversion (1c ; 18c ; 31c) pour sélectionner la bande passante du filtre IF (1 ; 18 ; 31), **caractérisé en ce que** :
- le détecteur de condition de réception (8) applique le signal de commande passe-bande au commutateur d'inversion (1c ; 18c ; 31c) du filtre IF (1 ; 18 ; 31) pour sélectionner le filtre passe-bande à bande étroite (1a ; 18a ; 31a) lorsqu'une dégradation de la condition de réception est détectée ;
- le détecteur de condition de réception (8) produit un signal de modification de période de déclenchement lorsque la dégradation de la condition de réception est détectée ; et
- le moyen d'annulation du bruit (4 ; 21 ; 34) possède un moyen de porte (15) et un moyen de commande (17) sensible au signal de modification de période de déclenchement pour modifier la période de déclenchement.

2. Récepteur F.M. selon la revendication 1, comprenant, de plus, un décodeur d'information de trafic (25) pour détecter une information de trafic multiplexée dans un signal principal d'un signal de diffusion et pour produire un signal d'information de trafic qui est appliqué au moyen d'annulation du bruit (21), le détecteur de condition de réception (8) étant prévu pour produire un signal de réduction afin de réduire le niveau du signal d'information de trafic lorsque la dégradation de la condition de réception est détectée.

3. Récepteur F.M. selon la revendication 1, comprenant, de plus, un moyen de modification du volume sonore (36), le détecteur de condition de réception (8) appliquant une commande du volume sonore au moyen de modification du volume (36) pour augmenter le volume lorsque la dégradation de la condition de réception est détectée.

4. Récepteur F.M. selon la revendication 1, dans lequel le moyen de porte (15) possède un multivibrateur monostable (13) pour modifier la période de déclenchement.
